# EUROPÄISCHE PATENTSCHRIFT

(11) **EP 2 057 677 B1**
(45) Veröffentlichungstag und Bekanntmachung des Hinweises auf die Patenterteilung: **23.01.2013**
(21) Anmeldenummer: 07803020.2
(22) Anmeldetag: 29.08.2007
(51) Int. Cl.: H01L 23/31, H01L 21/56, H05K 3/28

(54) **Verfahren zum Herstellen eines elektronischen Moduls**
Method for manufacturing an electronic module
Procédé pour fabriquer un module électronique

(30) Priorität: 31.08.2006 DE 102006040724
(43) Veröffentlichungstag der Anmeldung: 13.05.2009
(73) Patentinhaber: SIEMENS AKTIENGESELLSCHAFT, 80333 München (DE)
(72) Erfinder: WEIDNER, Karl, 81245 München (DE)
(86) Internationale Anmeldenummer: PCT/EP2007/059005
(87) Internationale Veröffentlichungsnummer: WO 2008/025805

(56) Entgegenhaltungen:
- EP-A- 1 093 159
- WO-A-88/02551
- DE-A1- 10 107 399

## Beschreibung

Die Erfindung betrifft ein Verfahren zum Herstellen eines elektronischen Moduls, welches ein Substrat umfasst, auf dem zumindest ein Bauelement, insbesondere ein Halbleiterchip, angeordnet ist.

Aus WO 88/02551 sind ein Verfahren und eine Vorrichtung bekannt, bei denen ein Polymerfilm auf ein unregulär geformtes Substrat bei relativ hohen Temperaturen aufbringbar ist. Dieses Verfahren ist besonders geeignet für VLSI-Chips.

Aus EP 1093159 A1 ist ein Verfahren zum Einkapseln von elektronischen Bauelementen bekannt, bei dem ein deformierbarer Film über den Bauelementen angeordnet ist und die Luft zwischen dem Film und den Bauelementen absaugbar ist. Dieses Verfahren ist besonders geeignet für Oberflächenwellenfilter-Bauelemente.

Aus DE 10107399 A1 ist ein elektronisches Bauteil mit Kantenschutz bekannt, bei dem ein elektronisches Bauteil eine damit mechanisch und elektrisch verbundene Umdrahtungsplatte mit Kontaktanschlüssen aufweist. Weiterhin weist sie eine Umhüllung zumindest der umlaufenden Kante der der Umdrahtungsplatte abgewandten Rückseite des elektronischen Bauteils mit einer flexiblen Schicht auf. Dadurch ist das insbesondere als Halbleiterchip ausgebildete elektronische Bauteil gegen mechanische Beschädigungen während der Handhabung geschützt.

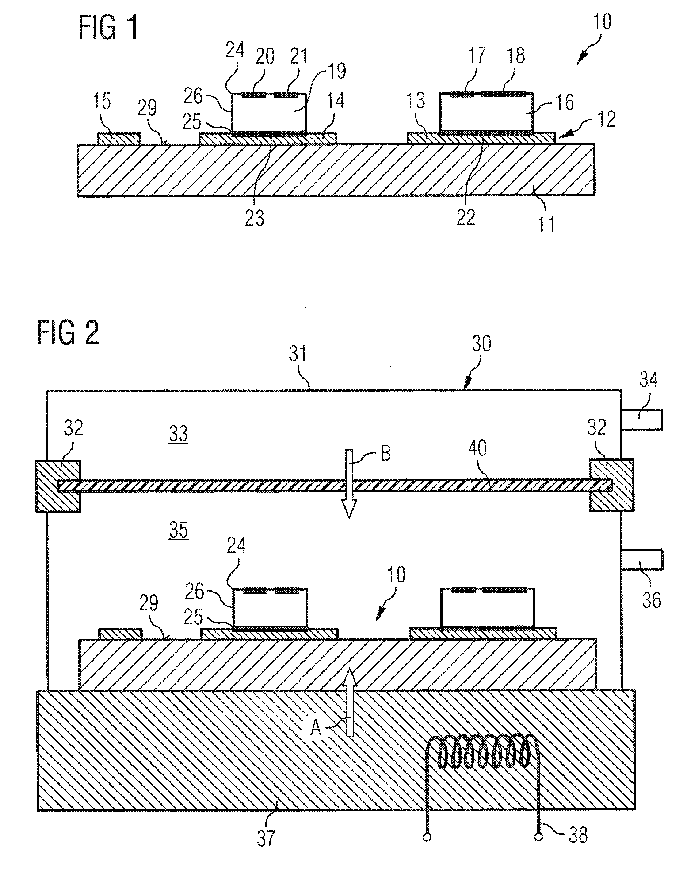

Ausgangspunkt bei der Herstellung des elektronischen Moduls ist ein in Fig. 1 im Querschnitt in schematischer Form dargestelltes Halbzeug des elektronischen Moduls. Dieses ist mit dem Bezugszeichen 10 gekennzeichnet. Auf einem Substrat 11 ist eine strukturierte Metallschicht 12 mit Metall- oder Kontaktflächen 13, 14, 15 aufgebracht. Auf den Kontaktflächen 13, 14 ist jeweils ein Bauelement 16, 19, z.B. ein Halbleiterchip, aufgebracht. Das Bauelement 16 ist über ein Verbindungsmittel 22, in der Regel ein Lot, mit der Kontaktfläche 13 verbunden. In entsprechender Weise ist das Bauelement 19 über ein Verbindungsmittel 23 mit der Kontaktfläche 14 verbunden. Sofern die Bauelemente 16, 19 einen Rückseitenkontakt, d.h. einen dem Substrat 11 zugewandten Kontakt aufweisen, so wird durch das Verbindungsmittel 22, 23 nicht nur eine mechanische, sondern auch eine elektrische Verbindung zu der jeweiligen Kontaktfläche 13 und/oder 14 hergestellt. Zur elektrischen Kontaktierung weisen die Bauelemente 16, 19 jeweils eine Anzahl an Kontaktflächen auf ihrer von dem Substrat 11 abgewandten Oberseite auf. Beispielhaft umfassen die Bauelemente 16, 19 jeweils zwei Kontaktflächen 17, 18 bzw. 20, 21. Die elektrische Verbindung zwischen den Kontaktflächen 17, 18 bzw. 20, 21 und der lediglich beispielhaft einen Kontaktfläche 15 geschieht üblicherweise unter Verwendung von Bonddrähten (nicht dargestellt).

Alternativ ist die Herstellung von elektrischen Verbindungen zwischen den Kontaktflächen 17, 18 bzw. 20, 21 der Bauelemente 16, 19 und der Kontaktfläche 15 durch eine sog. planare Verbindungstechnologie möglich, bei der eine Oberfläche 29 des Halbzeugs zunächst mit einer isolierenden Schicht bedeckt wird. An den Stellen der Kontaktflächen 15, 17, 18, 20, 21 werden Öffnungen in die isolierende Folie eingebracht, um die Kontaktflächen freizulegen. Anschließend wird eine Sputterschicht ganzflächig auf die Isolierfolie und deren eingebrachten Öffnungen aufgebracht. Die Sputterschicht besteht üblicherweise aus einer ca. 50 nm dicken Titan-Schicht und einer ca. 1 µm dicken Kupferschicht. Auf diese Sputterschicht wird eine weitere, in der Regel aus einem isolierenden Material bestehende lichtempfindliche Folie (sog. Fotofolie) aufgebracht. Die Dicke der Fotofolie beträgt zwischen 100 und 200 µm und wird in einem weiteren Schritt mit einer entsprechend der gewünschten leitenden Struktur belichtet und entwickelt.

Die Belichtung erfolgt üblicherweise mittels einer Maske, mit der das Layout der leitenden Struktur auf die Fotofolie übertragen wird. Dabei werden diejenigen Abschnitte der Fotofolie durch die Maske abgeschattet, welche die spätere elektrisch leitende Struktur ausbilden sollen. Die nicht belichteten Abschnitte der Fotofolie lassen sich in einem weiteren Verfahrensschritt entfernen, so dass eine Freilegung der darunter befindlichen Sputterschicht, genauer der Kupferoberfläche, erfolgt. Durch Eintauchen des vorbereiteten Halbzeugs in ein Elektrolytbad, insbesondere ein Kupfer-Elektrolytbad, wird durch galvanische Verstärkung eine ca. 100 bis 200 µm dicke Kupferschicht aufgewachsen. In einem sich daran anschließenden Schritt, der als Strippen der Fotofolie bezeichnet wird, wird die noch auf der Oberfläche befindliche Fotofolie an den Bereichen, an welchen keine elektrisch leitende Struktur ausgebildet werden soll, entfernt. Als letzter Schritt erfolgt ein sog. Differenzätzen, bei dem ganzflächig die aus Titan und Kupfer bestehende Sputterschicht entfernt wird, so dass lediglich die gewünschte leitfähige Struktur überbleibt.

Für die Zuverlässigkeit eines derart hergestellten elektronischen Moduls von entscheidender Bedeutung ist das Aufbringen der Isolierfolie auf die Oberfläche 29 des Halbzeugs 10. Die Qualität der Haftung und eventueller Lufteinschlüsse zwischen der Isolierfolie und der Oberfläche 29 können die elektrischen Eigenschaften zum einen beeinflussen oder sogar zur Zerstörung des elektronischen Moduls im Betrieb führen. Dies gilt insbesondere dann, wenn die Bauelemente 16, 19 Leistungshalbleiterbauelemente sind, welche zum Schalten von Spannungen im Bereich von 400 V bis 10 kV ausgebildet sind. Neben Isolationseigenschaften der Isolierfolie (üblicherweise im Bereich von 60 bis 100 kV/mm bei einer Dicke der Isolierfolie von 100 bis 400 µm) beeinflusst insbesondere das Vorhandensein von eventuellen Lufteinschlüssen den elektrischen Feldstärkebereich und damit die Eigenschaften des späteren elektronischen Moduls. Kritische Punkte sind dabei insbesondere die in Fig. 1 mit dem Bezugszeichen 24 versehene obere Seitenkante und die mit dem Bezugszeichen 25 versehene untere Seitenkante des Bauelements 19. Diese Problematik trifft, obwohl dies in der Figur mit Bezugszeichen nicht explizit dargestellt ist, auf alle entsprechenden Seitenkanten dieses und anderer Bauelemente zu.

Es ist daher Aufgabe der vorliegenden Erfindung, ein Verfahren zum Herstellen eines elektronischen Moduls anzugeben, welches die oben beschriebenen Probleme vermeidet und die Herstellung von elektronischen Modulen mit hoher Zuverlässigkeit ermöglicht.

Diese Aufgabe wird mit den Merkmalen des unabhängigen Patentanspruchs 1 gelöst. Vorteilhafte Ausführungsformen ergeben sich aus den abhängigen Patentansprüchen.

Bei dem erfindungsgemäßen Verfahren zum Herstellen eines elektronischen Moduls, welches ein Substrat umfasst, auf dem zumindest ein Bauelement, insbesondere ein Halbleiterchip, angeordnet ist, wird als zumindest ein Verfahrensschritt eine Folie aus Kunststoffmaterial auf eine zumindest eine Kontaktfläche umfassende Oberfläche des Substrats und des zumindest einen Bauelements auflaminiert. Dieser Verfahrensschritt umfasst die Schritte: ein die auf die Oberfläche des Substrats und des zumindest einen Bauelements aufzulaminierende Folie umfassender Folienverbund wird derart in einer Kammer angeordnet, dass die Kammer durch den Folienverbund in einem ersten Kammerabschnitt und einem zweiten, davon gasdicht getrennten Kammerabschnitt aufgeteilt wird; in dem ersten Kammerabschnitt wird ein höherer atmosphärischer Druck als in dem zweiten Kammerabschnitt bereitgestellt oder erzeugt; es wird ein Kontakt der Oberfläche des in dem zweiten Kammerabschnitt angeordneten Substrats mit dem zumindest einen Bauelement und dem Folienverbund hergestellt, durch welchen das Laminieren der Folie auf die Oberfläche bewirkt wird.

Durch das erfindungsgemäße Verfahren kann ein blasenfreies Aufbringen der Folie auf die Oberfläche des Halbzeugs aus einem Substrat und dem zumindest einen Bauelement sichergestellt werden, wodurch die Ausschussquote fertig gestellter elektronischer Module verringert wird. Darüber hinaus weist das Verfahren den Vorteil auf, dass das Aufbringen der Folie sehr schnell erfolgen kann, wodurch sich die Fertigungszeit zur Herstellung des elektronischen Moduls verkürzt und damit geringere Herstellungskosten die Folge sind.

Ein elektronisches Modul mit einem Substrat, auf dem zumindest ein Bauelement, insbesondere ein Halbleiterchip, angeordnet ist, wobei eine Folie aus Kunststoffmaterial auf eine Oberfläche des Substrats und des zumindest einen Bauelements auflaminiert ist, zeichnet sich dadurch aus, dass die Folie an geraden Kanten und an Biegungen die gleiche Dicke aufweist. Hierdurch sind die Feldstärkeeigenschaften, insbesondere bei der Verwendung von Leistungshalbleiterbauelementen, im Voraus genau bestimmbar, wodurch die Qualität eines derartigen Moduls insgesamt erhöht werden kann. Insbesondere ist dadurch die Gefahr von Spannungsüberschlägen zwischen der auf der Folie ausgebildeten elektrisch leitenden Struktur und einer Kontaktfläche des Bauelements verringert. Weiterhin ist die Gefahr durch Zerstörung aufgrund von Überhitzung verringert.

Um eine gasdichte Trennung der Kammer in dem ersten und dem zweiten Kammerabschnitt und die Bereitstellung eines Druckgefälles bewerkstelligen zu können, ist die Folie gemäß einer ersten Variante ganzflächig ausgebildet. Erst in einem dem Laminieren nachfolgenden Verfahrensschritt wird die Folie mit einer Öffnung im Bereich der zumindest einen Kontaktfläche versehen, um das Aufbringen einer elektrisch leitenden Struktur im Weiteren vornehmen zu können.

Erfindungsgemäß wird zur Bildung des Folienverbunds die Folie mit zumindest einer Öffnung versehen und auf eine als Abformfolie dienende ganzflächige und gasdichte Folie aus einem Kunststoff aufgebracht. Die gasdichte Trennung wird damit nicht durch die aufzulaminierende Folie (Isolierfolie), sondern durch die Abformfolie bereitgestellt. Als Material für die Abformfolie wird ein Material verwendet, welches beim Schritt des Laminierens "weicher" als die zu laminierende Folie ist. Hierdurch wird sichergestellt, dass sich beim Auflaminieren der Folie auf die Oberfläche des Substrats mit dem zumindest einen Bauelement keine Einschlüsse zwischen der Folie und dem Bauelement ergeben können. Die Abformfolie "umfließt" die Folie von der dem Substrat gegenüber liegenden Seite und übt weiterhin einen Druck beim Aufbringen der Folie aus.

Der Folienverbund wird derart in der Kammer angeordnet, dass die zu laminierende Folie dem zweiten Kammerabschnitt zugewandt ist. Zweckmäßigerweise wird der Folienverbund derart in der Kammer angeordnet, dass die zumindest eine Öffnung in der Folie beim Laminieren im Bereich einer korrespondierenden Kontaktfläche zum Liegen kommt. Nach dem Schritt des Laminierens der Folie auf die Oberfläche wird die Abformfolie von der auflaminierten Folie abgelöst.

Die Verwendung eines Folienverbunds weist den Vorteil auf, dass der üblicherweise durchzuführende Schritt des Einbringens von Öffnungen im Bereich der zumindest einen Kontaktfläche entfallen kann. Üblicherweise wird das Einbringen von Öffnungen unter Verwendung von Lasern vorgenommen. Der Einsatz derartiger Laser ist aufgrund der dafür benötigten langen Zeitdauer jedoch sehr kostenintensiv. Die Verwendung eines Folienverbunds im Rahmen des erfindungsgemäßen Herstellungsverfahrens ermöglicht einen vollständigen Verzicht auf den Einsatz derartiger Laservorrichtungen, wodurch die Kosten der Herstellung und die Zeitdauer für die Herstellung des elektronischen Moduls verringert werden können.

Zum Aufbringen der Folie oder des Folienverbunds auf die Oberfläche des Halbzeugs ist es ausreichend, einen Druckunterschied zwischen dem ersten und dem zweiten Kammerabschnitt bereitzustellen. Zur Vermeidung von Lufteinschlüssen zwischen der Folie und der Oberfläche des Halbzeugs ist es jedoch vorteilhaft, den zweiten Kammerabschnitt, in welchem sich das Halbzeug befindet, zu evakuieren. Es ist dabei ausreichend, wenn gemäß einer weiteren Ausführungsform in dem ersten Kammerabschnitt zumindest ein isostatischer Druck herrscht.

Gegebenenfalls kann vorgesehen sein, zur Erhöhung des Drucks in dem ersten Kammerabschnitt in den ersten Kammerabschnitt ein Gas, insbesondere Sauerstoff oder weiter bevorzugt Stickstoff, oder auch ein Gel zu fördern. Die Erhöhung des Drucks in dem ersten Kammerabschnitt sorgt für ein schnelleres Anlegen der Folie an der Oberfläche und verringert weiterhin die Gefahr von Lufteinschlüssen. Am meisten bevorzugt ist die Verwendung von Stickstoff zur Erhöhung des Drucks in dem ersten Kammerabschnitt, da Stickstoff und die auf die Oberfläche aufzulaminierende Folie keinerlei Reaktion zueinander aufweisen. Damit kann eine Schwächung der Folie bereits im Rahmen der Fertigung vermieden werden.

Eine weitere Verbesserung der Verbindungsqualität ergibt sich, wenn das Substrat mit dem zumindest einen Bauelement auf einer beheizbaren Bodenplatte der Kammer angeordnet wird, wobei durch die Bodenplatte sowohl das Substrat mit dem zumindest einen Bauelement als auch der zweite Kammerabschnitt definiert erwärmt werden. Es haben sich dabei Betriebstemperaturen im Bereich von 150 bis 200 °C als zweckmäßig herausgestellt, da in diesem Temperaturbereich die Verbindung der Folie und der Oberfläche zuverlässig vornehmbar ist und gleichzeitig die auf dem Substrat befindlichen Bauelemente nur wenig belastet werden.

Zur Herstellung des Kontakts zwischen der Oberfläche des in dem zweiten Kammerabschnitt angeordneten Substrats mit dem zumindest einen Bauelement und dem Folienverbund wird eine Relativbewegung der Kontaktpartner zueinander hergestellt. Dabei ist es unerheblich, ob das Halbzeug oder die Folie bewegt wird. Denkbar ist auch, dass sowohl das Halbzeug als auch die Folie aufeinander zu bewegt werden.

In einem weiteren zweckmäßigen Verfahrensschritt ist vorgesehen, dass vor dem Schritt des Laminierens an im Wesentlichen senkrecht zu dem Substrat verlaufenden Abschnitten des zumindest einen Bauelements Flanken erzeugt werden, welche Seitenkanten des Bauelements mit dem Substrat in einem stetigen Übergang verbinden: Obwohl das erfindungsgemäße Verfahren auch ohne das Vorsehen derartiger Flanken eine zuverlässige Anlage der Folie an senkrecht verlaufenden Abschnitten des zumindest einen Bauelements sicherstellt, können durch das Vorsehen derartiger Flanken die von der Folie angenommenen Winkel verringert bzw. "entschärft" werden. Der Vorteil des Vorsehens derartiger Flanken besteht insbesondere darin, dass bei einem späteren Schritt des Belichtens einer lichtempfindlichen Folie zur Erzeugung einer elektrisch leitenden Struktur auch eine Belichtung der Fotofolie nahe bzw. an den senkrecht verlaufenden Abschnitten zuverlässig erfolgt. Insbesondere ist hierdurch der Einsatz von Maskentechnik zur Belichtung der lichtempfindlichen Folie möglich.

Zum Nach- oder Aushärten der laminierten Folie kann der Verbund (aus Folie und Substrat mit dem zumindest einen Bauelement) bei einem vorgegebenen Temperaturverlauf, insbesondere bei einer gegenüber dem Laminationsvorgang erhöhten Temperatur, für eine vorbestimmte Zeit in der Kammer verbleiben. Dies weist den Vorteil auf, dass neben der Kammer keine zusätzliche Vorrichtung zum Härten des Verbunds vorgesehen werden muss. Die Kosten für die Bereitstellung des Fertigungs-Equipment lassen sich dadurch verringern.

Alternativ kann auch vorgesehen sein, dass zum Nach- oder Aushärten der laminierten Folie das Halbzeug in einem Härteofen bei einer vorgegebenen Temperatur für eine vorbestimmte Zeit verbleibt.

Das erfindungsgemäße Verfahren kann sowohl zum Auflaminieren der unmittelbar auf die Oberfläche des Substrats und des zumindest einen Bauelements aufzubringenden Isolierfolie als auch der im Rahmen eines späteren Verfahrensschritts aufzubringenden lichtempfindlichen Folie verwendet werden. Als auf die Oberfläche zu laminierende Folie wird deshalb eine Isolierfolie oder eine lichtempfindliche Folie (Fotofolie), insbesondere aus einem isolierenden Material, gewählt.

Wie aus der vorangegangen Beschreibung bereits ersichtlich wurde, lässt sich das erfindungsgemäße Verfahren insbesondere bei Oberflächen mit einer dreidimensionalen Struktur besonders vorteilhaft anwenden. Unabhängig davon ist auch das Auflaminieren einer Folie auf eine zweidimensionale Oberfläche möglich.

Die Erfindung wird nachfolgend weiterhin anhand eines Ausführungsbeispiels in der Figur näher erläutert. Es zeigen:
- Fig. 1: eine schematische Darstellung eines elektronischen Moduls als Halbzeug in einer Querschnittsdarstellung,
- Fig. 2: eine schematische Darstellung einer Vorrichtung zum Herstellen eines elektronischen Moduls,
- Fig. 3: eine schematische Darstellung eines elektronischen Moduls als Halbzeug, auf welche eine Folie auflaminiert ist,
- Fig. 4: eine schematische Darstellung eines Folienverbunds, und
- Fig. 5: ein zweites Ausführungsbeispiel eines elektronischen Moduls als Halbzeug, auf das eine Folie auflaminiert ist.

Der prinzipielle Aufbau eines elektronischen Moduls 10 als Halbzeug in Fig. 1 wurde bereits in der Beschreibungseinleitung erläutert. Bei dem Substrat kann es sich beispielsweise um eine Keramik, ein Printed Circuit Board (PCB), ein Leadframe oder ein Flextape handeln. Die Bauelemente 16, 19 stellen beispielsweise Leistungshalbleiterbauelemente dar, welche zum Schalten hoher Spannungen im Bereich von 400 V bis 10 kV ausgebildet sind. Leistungshalbleiterbauelemente sind üblicherweise mit Kontaktflächen auf ihrer Vorder- und Rückseite versehen. So stellt beispielsweise die Kontaktfläche 20 des Bauelements 19 einen Steueranschluss (Gate), die Kontaktfläche 21 einen Source-Anschluss und ein Rückseitenkontakt (nicht dargestellt), der in elektrischer Verbindung mit der Kontaktfläche 14 steht, einen Drain-Kontakt dar. In entsprechender Weise kann die Aufteilung der Kontaktflächen 17, 18 des Bauelements 16 sein.

Entgegen der zeichnerischen Darstellung müssen die Höhen der Bauteile 16, 19 auf dem Substrat nicht identisch ausgebildet sein. Es ist sogar möglich, mit dem vorliegenden Verfahren auch passive Bauelemente auf der Oberfläche 29 aufzubringen, z.B. Kondensatoren, mit der Isolationsfolie zu bedecken und in den weiteren Verfahrensschritten zu prozessieren.

Die auf die Oberfläche 29 aufzubringende Isolationsfolie weist an die Bauelemente 16, 19 angepasste, im Ausführungsbeispiel hohe Isolationseigenschaften auf, welche zur Aufnahme von 60 bis 100 kV/mm fähig ist. Die Dicke der Isolationsfolie, welche auf die Oberfläche 29 aufzubringen ist, kann z.B. je nach Anwendung zwischen 100 und 400 µm variieren, abhängig von der zu isolierenden Spannung. Die Materialeigenschaften der Isolationsfolie sind derart gewählt, dass eine Dauertemperaturbelastung von 150 bis 200 °C zu keinen Beschädigungen der Isolationsfolie führt. In der Praxis sind derzeit Dauertemperaturbelastungen von 125 °C ausreichend.

Fig. 2 zeigt in schematischer Darstellung eine Vorrichtung zum Auflaminieren einer Isolationsfolie auf das in Fig. 1 dargestellte Halbzeug 10. Die Vorrichtung 30 umfasst eine Kammer 31 mit einer Bodenplatte 37, Seitenwänden und einem Dach. In der Bodenplatte 37 ist eine Heizung 38 zur Beheizung der Bodenplatte 37 und des Inneren der Kammer 31 angeordnet. Im Inneren der Kammer 31 und auf der Bodenplatte 37 wird das in Fig. 1 beschriebene Halbzeug 10 angeordnet. Die in einem Rahmen 32 eingespannte Isolierfolie 40 trennt die Kammer 31 gasdicht voneinander in einen ersten Kammerabschnitt 33 und einen zweiten Kammerabschnitt 35, in welchem das Halbzeug 10 angeordnet ist. Jeder der Kammerabschnitte 33, 35 ist beispielhaft an einer Seitenwand mit einem Rohrstutzen 34 bzw. 36 versehen. Über den Rohrstutzen 36 kann der zweite Kammerabschnitt 35 evakuiert werden. Über den Rohrstutzen 34 kann beispielsweise ein Gas oder Gel in den ersten Kammerabschnitt 33 eingeleitet werden, um den in dem ersten Kammerabschnitt 33 herrschenden Druck über den isostatischen Druck hinaus zu erhöhen.

Während des Laminiervorgangs wird ein Druckgefälle zwischen dem ersten und dem zweiten Kammerabschnitt 33, 35 erzeugt. Gleichzeitig wird die Heizung 38 in der Bodenplatte 37 eingeschaltet, um sowohl das Halbzeug 10 als auch das Innere des zweiten Kammerabschnitts 35 zu erwärmen. Die dabei erreichten Temperaturen bewegen sich im Bereich von 50 bis 200 °C, wobei die auf dem Substrat aufgebrachten Bauelemente keinerlei Schädigung unterworfen sind. Sodann wird eine Relativbewegung des Halbzeugs 10 und der Folie 40 aufeinander zu ausgeführt. Die Relativbewegung kann durch eine Bewegung der Bodenplatte 37 mit dem Halbzeug 10 in der mit dem Bezugszeichen A gekennzeichneten Pfeilrichtung erfolgen. Alternativ oder zusätzlich kann eine Bewegung des Rahmens 32 mit der daran befestigten Folie 40 in Richtung der Oberfläche 29 des Halbzeugs 10 erfolgen. Aufgrund der Erwärmung durch die Heizung 38 und des herrschenden Druckunterschiedes schmiegt sich die aus einem weichen Material bestehende Folie 40 an die Oberfläche 29 des Halbzeugs 10 an und folgt dabei der Kontur der Oberfläche 29. Aufgrund des in dem zweiten Kammerabschnitt herrschenden Vakuums können Lufteinschlüsse zwischen der ganzflächigen Folie 40 und der Oberfläche 29 des Halbzeugs 10 vermieden werden.

Durch eine geeignete Materialauswahl der Folie, eine geeignete Einstellung der Temperatur in der Kammer 31 und eine entsprechende Wahl der in dem ersten und dem zweiten Kammerabschnitt 33, 35 herrschenden Drücke ist eine Umformung der Folie 40 an die Oberfläche 29 derart möglich, dass die Folie 40 im Bereich von Biegungen keine Variation ihrer Dicke erfährt. Dies bedeutet, dass insbesondere an den Seitenkanten 24, 25 keinerlei Querschnittsänderungen der Isolierfolie auftreten. Weiterhin ist durch das erfindungsgemäße Verfahren sichergestellt, dass die Isolierfolie an den senkrecht verlaufenden Abschnitten der Bauelemente 16, 19 (vgl. Bezugszeichen 26) eng anliegt.

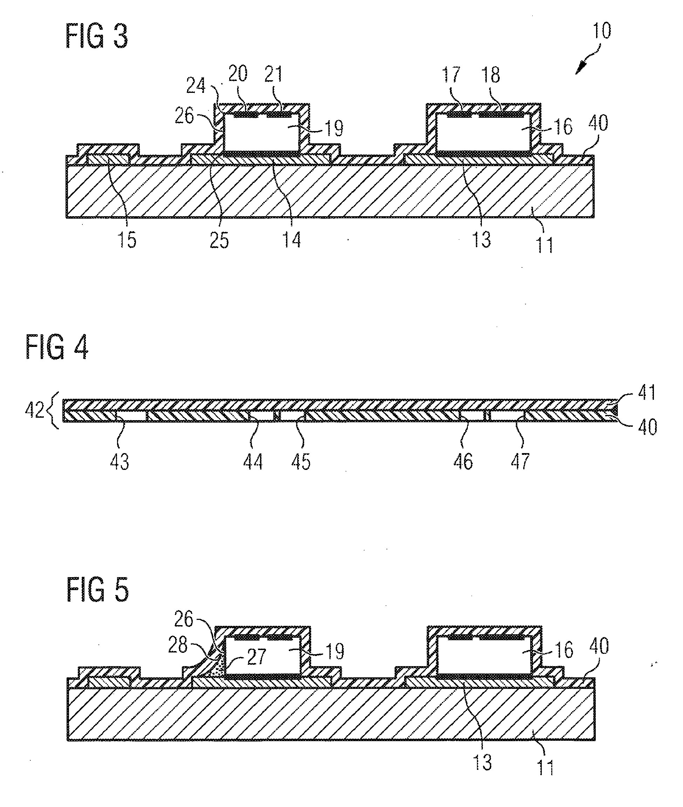

Das Aufbringen bzw. Laminieren der Folie 40 auf die Oberfläche 29 des Halbzeugs 10 erfolgt, indem die weichen, viskosen Eigenschaften der Folie 40 ausgenutzt werden. Für den späteren Betrieb ist ein Aushärten der Isolierfolie 40 erforderlich. Zum Aushärten kann der aus dem Halbzeug 10 und der Folie bestehende Verbund, der in Fig. 3 dargestellt ist, in der Vorrichtung 30 verbleiben oder aus der Vorrichtung 30 entnommen und in einen separaten Härteofen verbracht werden. Zum Aushärten ist es zweckmäßig, wenn gegenüber dem Laminationsvorgang höhere Temperaturen auf den Verbund einwirken.

Nach dem Aufbringen und Aushärten der Folie kann der Verbund weiter verarbeitet werden, indem in die Isolierschicht 40 im Bereich der Kontaktflächen 15, 17, 18, 20, 21 Öffnungen eingebracht werden. Das Einbringen der Öffnungen erfolgt üblicherweise unter Verwendung eines Lasers. Hieran schließt sich das bereits beschriebene Aufbringen einer Sputterschicht, das Aufbringen einer lichtempfindlichen, aus einem isolierenden Material bestehenden Folie, das Belichten und Entwickeln sowie das galvanische Abscheiden einer elektrisch leitenden Struktur an. Das Aufbringen der lichtempfindlichen Folie (Fotofolie) kann unter Anwendung des beschriebenen Verfahrens in der in Fig. 2 gezeigten Vorrichtung erfolgen.

Fig. 5 zeigt den Verbund aus Substrat und dem zumindest einen Bauelement 16, 19 und der aufgebrachten Folie 40 in einer abgewandelten schematischen Darstellung, ebenfalls in einem Querschnitt. Vor dem Aufbringen der Folie 40 wurde an dem Abschnitt 26 eine Flanke 28 erzeugt, indem ein isolierendes Material an den Abschnitt 26 aufgebracht, z.B. dispenst, wurde. Das z.B. in flüssiger Form aufgebrachte isolierende Material saugt sich aufgrund von Kapillarkräften an die Seitenwand (den Abschnitt 26) des Bauelements 19 an, so dass keine Gaseinschlüsse entstehen. Hierbei ergibt sich die in der Figur gezeigte Flanke 28 mit einem Kanten vermeidenden Verlauf. Beim Aufbringen der Folie 40 in der in Fig. 2 beschriebenen Vorrichtung passt sich die Folie 40 an den Verlauf der Flanke 28 an.

Im Ausführungsbeispiel der Fig. 5 wurde lediglich beispielhaft eine einzige Flanke 28 eingezeichnet, wobei dies lediglich zu Zwecken der Illustration gemacht wurde. Das Vorsehen derartiger Flanken 28 weist bei der weiteren Herstellung des elektronischen Moduls den Vorteil auf, dass auch die im Weiteren aufgebrachte lichtempfindliche Fotofolie die Gestalt der Flanke 28 annimmt. Beim Belichten der Fotofolie müssen nunmehr nicht mehr besondere Vorkehrungen getroffen werden, um auch die senkrecht verlaufenden Abschnitte der Fotofolie zu belichten. Das Vorsehen der Flanken eliminiert weitestgehend senkrecht verlaufende Abschnitte zunächst der Isolierfolie und im Weiteren der Fotofolie, so dass die Belichtung mit herkömmlichen Masken erfolgen kann.

In einer Abwandlung der Erfindung wird zum Aufbringen der Folie 40 ein Folienverbund 42 (vgl. Fig. 4) in den Rahmen 32 der Vorrichtung 30 eingespannt. Der Folienverbund umfasst die Folie 40, in der bereits Öffnungen 43, 44, 45, 46, 47 an den Stellen der Kontaktflächen 15, 17, 18, 20, 21 eingebracht sind. Um einen gasdichten Abschluss zwischen dem ersten Kammerabschnitt und dem zweiten Kammerabschnitt 33, 35 bereitstellen zu können, umfasst der Folienverbund ferner eine mit der Folie 40 verbundene ganzflächige und gasdichte Abformfolie 41. Die Abformfolie 41 besteht bevorzugt aus einem "weicheren" Material als die Folie 40, um das Anschmiegen der Folie 40 beim Laminiervorgang an die dreidimensionale strukturiere Oberfläche 29 des Halbzeugs 10 unterstützen zu können.

Nach dem Auflaminieren des Folienverbunds 42 auf die Oberfläche 29 des Halbzeugs 10 findet in der bereits beschriebenen Weise ein Aushärten statt. Hernach wird die Abformfolie 41 von der Folie 40 abgelöst. Bei der Auswahl der Materialien der Folie 40 und der Abformfolie 41 muss deshalb sichergestellt werden, dass sowohl während des Laminiervorgangs als auch während des Nachhärtens keine Vernetzung zwischen diesen beiden Partnern stattfindet, um zu verhindern, dass beim Ablösen der Abformfolie 41 ein auch nur teilweises Ablösen der Folie 40 von der Oberfläche 29 des Halbzeugs 10 erfolgt. Dies kann sowohl durch eine geeignete Materialauswahl als auch durch die Einstellung geeigneter Prozessparameter sichergestellt werden.

Da der Verbund aus Substrat 11 mit dem zumindest einen Bauelement 16, 19 und der Folie 40 bereits die Öffnungen 43, 44, 45, 46, 47 im Bereich der Kontaktflächen 15, 17, 18, 20, 21 aufweist, kann auf das Einbringen der Öffnungen mittels eines Lasers verzichtet werden. Im Weiteren kann somit sofort mit dem Aufbringen einer Sputterschicht begonnen werden.

## Patentansprüche

1. Verfahren zum Herstellen eines elektronischen Moduls, welches ein Substrat (11), auf dem zumindest ein Bauelement (16, 19), insbesondere ein Halbleiterchip, angeordnet ist, umfasst, bei dem als zumindest ein Verfahrensschritt eine Folie (40) aus Kunststoffmaterial auf eine zumindest eine Kontaktfläche umfassende Oberfläche (29) des Substrats (11) und des zumindest einen Bauelements (16, 19) auflaminiert wird, mit den Schritten:
- ein die auf die Oberfläche (29) des Substrats (11) und des zumindest einen Bauelements (16, 19) aufzulaminierende Folie (40) umfassender Folienverbund (42) wird derart in einer Kammer (31) angeordnet, dass die Kammer (31) durch den Folienverbund (42) in einen ersten Kammerabschnitt (33) und einen zweiten, davon gasdicht getrennten Kammerabschnitt (35) aufgeteilt wird;
- in dem ersten Kammerabschnitt (33) wird ein höherer atmosphärischer Druck als in dem zweiten Kammerabschnitt (35) bereitgestellt oder erzeugt; und
- es wird ein Kontakt der Oberfläche (29) des in dem zweiten Kammerabschnitt angeordneten Substrats (11) mit dem zumindest einen Bauelement (16, 19) und dem Folienverbund (42) hergestellt, durch welchen das Laminieren der Folie (40) auf die Oberfläche (29) bewirkt wird, wobei
zur Bildung des Folienverbunds (42) die Folie (40) mit zumindest einer Öffnung (43, 44, 45, 46, 47) versehen wird und auf eine als Abformfolie (41) dienende ganzflächige und gasdichte Folie (40) aus einem Kunststoff aufgebracht wird, und
als Material für die Abformfolie (41) ein Material verwendet wird, welches beim Schritt des Laminierens weicher als die zu laminierende Folie (40) ist.

2. Verfahren nach Anspruch 1,
**dadurch gekennzeichnet, dass**
die Folie (40) ganzflächig ausgebildet ist und in einem dem Laminieren nachfolgenden Verfahrensschritt mit einer Öffnung im Bereich der zumindest einen Kontaktfläche versehen wird.

3. Verfahren nach Anspruch 1,
**dadurch gekennzeichnet, dass**
der Folienverbund (42) derart in der Kammer (31) angeordnet wird, dass die zu laminierende Folie (40) dem zweiten Kammerabschnitt (35) zugewandt ist.

4. Verfahren nach einem der Ansprüche 1 oder 2,
**dadurch gekennzeichnet, dass**
der Folienverbund (42) derart in der Kammer (31) angeordnet wird, dass die zumindest eine Öffnung (43, 44, 45, 46, 47) in der Folie (40) beim Laminieren im Bereich einer korrespondierenden Kontaktfläche (15, 17, 18, 20, 21) zum Liegen kommt.

5. Verfahren nach einem der vorherigen Ansprüche,
**dadurch gekennzeichnet, dass**
die Abformfolie (41) nach dem Schritt des Laminierens der Folie (40) auf die Oberfläche (29) abgelöst wird.

6. Verfahren nach einem der vorherigen Ansprüche,
**dadurch gekennzeichnet, dass**
der zweite Kammerabschnitt (35) evakuiert wird.

7. Verfahren nach einem der vorherigen Ansprüche,
**dadurch gekennzeichnet, dass**
in dem ersten Kammerabschnitt (33) zumindest ein isostatischer Druck herrscht.

8. Verfahren nach einem der vorherigen Ansprüche,
**dadurch gekennzeichnet, dass**
zur Erhöhung des Drucks in dem ersten Kammerabschnitt (33) in den ersten Kammerabschnitt (33) ein Gas, insbesondere Sauerstoff oder weiter bevorzugt Stickstoff, oder ein Gel gefördert wird.

9. Verfahren nach einem der vorherigen Ansprüche,
**dadurch gekennzeichnet, dass**
das Substrat (11) mit dem zumindest einen Bauelement (16, 19) auf einer beheizbaren Bodenplatte (37) der Kammer (31) angeordnet wird, wobei durch die Bodenplatte (37) sowohl das Substrat (11) mit dem zumindest einen Bauelement (16, 19) als auch der zweite Kammerabschnitt (35) definiert erwärmt werden.

10. Verfahren nach einem der vorherigen Ansprüche,
**dadurch gekennzeichnet, dass**
der Kontakt zwischen der Oberfläche (29) des in dem zweiten Kammerabschnitt (35) angeordneten Substrats (11) mit dem zumindest einen Bauelement (16, 19) und dem Folienverbund (42) durch eine Relativbewegung der Kontaktpartner zueinander hergestellt wird.

11. Verfahren nach einem der vorherigen Ansprüche,
**dadurch gekennzeichnet, dass**
vor dem Schritt des Laminierens an im Wesentlichen senkrecht zu dem Substrat (11) verlaufenden Abschnitte (26) des zumindest einen Bauelements (16, 19) Flanken (28) erzeugt werden, welche Seitenkanten (24, 25) des Bauelements (16, 19) mit dem Substrat (11) in einem stetigen Übergang verbinden.

12. Verfahren nach einem der vorherigen Ansprüche,
**dadurch gekennzeichnet, dass**
zum Nach- oder Aushärten der laminierten Folie (40) der Verbund bei einem vorgegebenen Temperaturverlauf, insbesondere bei einer gegenüber dem Laminationsvorgang erhöhten Temperatur, für eine vorbestimmte Zeit in der Kammer (31) verbleibt.

13. Verfahren nach einem der vorherigen Ansprüche,
**dadurch gekennzeichnet, dass**
zum Nach- oder Aushärten der laminierten Folie (40) das Halbzeug in einem Härteofen bei einer vorgegebenen Temperatur für eine vorbestimmte Zeit verbleibt.

14. Verfahren nach einem der vorherigen Ansprüche,
**dadurch gekennzeichnet, dass**
als auf die Oberfläche (29) zu laminierende Folie (40) eine Isolierfolie oder eine lichtempfindliche Folie (40) (Fotofolie), insbesondere aus einem isolierenden Material, gewählt wird.

15. Verfahren nach einem der vorherigen Ansprüche,
**dadurch gekennzeichnet, dass**
die Oberfläche (29), auf welche die Folie (40) laminiert wird, eine dreidimensionale Struktur aufweist.

## Claims

1. Method for manufacturing an electronic module which comprises a substrate (11) on which at least one component (16, 19), in particular a semiconductor chip, is arranged, wherein as at least one method step a film (40) made of a plastic material is laminated onto a surface (29) of the substrate (11) and of the at least one component (16, 19), said surface (29) comprising at least one contact area, with the following steps:
- the film (40) to be laminated onto the surface (29) of the substrate (11) and of the at least one component (16, 19) or a film composite (42) comprising the film (40) is arranged in a chamber (31) such that the chamber (31) is divided by the the film composite (42) into a first chamber section (33) and a second chamber section (35) that is isolated from the first in a gastight manner;
- a higher atmospheric pressure is provided or produced in the first chamber section (33) than in the second chamber section (35); and
- contact is established between the surface (29) of the substrate (11) with the at least one component (16, 19) arranged in the second chamber section and the film (40) or the film composite (42), causing the film (40) to be laminated onto the surface (29), wherein
to form the film composite (42) the film (40) is provided with at least one opening (43, 44, 45, 46, 47) and applied to a full-coverage and gas-tight film (40) made of a plastic material and serving as a forming film (41) and
a material used for the forming film (41) is a material that is "softer" than the film (40) to be laminated during the lamination step

2. Method according to claim 1,
**characterised in that**
the film (40) is embodied to provide full coverage and is provided with an opening in the region of the at least one contact area in a method step following lamination.

3. Method according to claim 1,
**characterised in that**
the film composite (42) is arranged in the chamber (31) such that the film (40) to be laminated faces the second chamber section (35).

4. Method according to one of claims 1 or 2,
**characterised in that**
the film composite (42) is arranged in the chamber (31) such that the at least one opening (43, 44, 45, 46, 47) in the film (40) comes to be positioned in the region of a corresponding contact area (15, 17, 18, 20, 21) during lamination.

5. Method according to one of the preceding claims,
**characterised in that**
after the step of laminating the film (40) onto the surface (29), the forming film (41) is detached.

6. Method according to one of the preceding claims,
**characterised in that**
the second chamber section (35) is evacuated.

7. Method according to one of the preceding claims,
**characterised in that**
there is at least an isostatic pressure in the first chamber section (33).

8. Method according to one of the preceding claims,
**characterised in that**
to increase the pressure in the first chamber section (33), a gas, in particular oxygen or more preferably nitrogen, or a gel is conveyed into the first chamber section (33).

9. Method according to one of the preceding claims,
**characterised in that**
the substrate (11) with the at least one component (16, 19) is arranged on a heatable baseplate (37) of the chamber (31), with both the substrate (11) with the at least one component (16, 19) as well as the second chamber section (35) being heated in a defined manner by means of the baseplate (37).

10. Method according to one of the preceding claims,
**characterised in that**
the contact between the surface (29) of the substrate (11) with the at least one component (16, 19) arranged in the second chamber section (35) and the composite (42) is established by means of a movement of the contact partners relative to one another.

11. Method according to one of the preceding claims,
**characterised in that**
slopes (28) are produced on sections (26) of the at least one component (16, 19) that run essentially perpendicular to the substrate (11) before the lamination step, said slopes connecting lateral edges (24, 25) of the component (16, 19) to the substrate (11) in a continuous transition.

12. Method according to one of the preceding claims,
**characterised in that**
to post-cure or harden the laminated film (40), the composite remains in the chamber (31) for a predetermined time with a predefined temperature profile, in particular at a higher temperature than that of the lamination process.

13. Method according to one of the preceding claims,
**characterised in that**
the semifinished product remains in a hardening oven at a predefined temperature for a predetermined time to post-cure or harden the laminated film (40).

14. Method according to one of the preceding claims,
**characterised in that**
an insulating film or a light-sensitive film (40) (photofilm), in particular made of an insulating material, is selected as the film (40) to be laminated onto the surface (29).

15. Method according to one of the preceding claims,
**characterised in that**
the surface (29) onto which the film (40) is laminated has a three-dimensional structure.

## Revendications

1. Procédé de fabrication d'un module électronique qui comprend un substrat (11) sur lequel au moins un composant (16, 19), notamment une puce semi-conductrice, est disposé, dans lequel, en tant qu'au moins une étape de procédé, une feuille (40) en matière plastique est laminée sur une surface (29) du substrat (11) et du au moins un composant (16, 19) comprenant au moins une surface de contact, comprenant les étapes :
- un matériau composite en feuille (42) comprenant la feuille (40) à laminer sur la surface (29) du substrat (11) et de l'au moins un composant (16, 19) est disposé dans une chambre (31) de telle sorte que la chambre (31) est divisée, par le matériau composite en feuille (42), en une première partie de chambre (33) et une seconde partie de chambre (35) séparée de la première d'une manière étanche au gaz ;
- une pression atmosphérique plus élevée est fournie ou produite dans la première partie de chambre (33) que dans la seconde partie de chambre (35) ; et
- un contact de la surface (29) du substrat (11) placé dans la seconde partie de chambre avec l'au moins un composant (16, 19) et le matériau composite en feuille (42) est créé, grâce auquel le laminage de la feuille (40) sur la surface (29) est réalisé,
la feuille (40) étant pourvue d'au moins une ouverture (43, 44, 45, 46, 47), pour la formation du matériau composite en feuille (42), et étant appliquée sur une feuille (40) en matière plastique étanche au gaz et couvrant toute la surface qui sert de feuille coulée (41) et une matière plus molle que la feuille (40) à laminer lors de l'étape du laminage étant utilisée comme matière pour la feuille coulée (41).

2. Procédé selon la revendication 1, **caractérisé en ce que** la feuille (40) est exécutée en pleine surface et est pourvue, dans une étape de procédé succédant au laminage, d'une ouverture dans la zone de l'au moins une surface de contact.

3. Procédé selon la revendication 1, **caractérisé en ce que** le matériau composite en feuille (42) est disposé dans la chambre (31) de telle sorte que la feuille (40) à laminer est tournée du côté de la seconde partie de chambre (35).

4. Procédé selon l'une des revendications 1 ou 2, **caractérisé en ce que** le matériau composite en feuille (42) est disposé dans la chambre (31) de telle sorte que l'au moins une ouverture (43, 44, 45, 46, 47) dans la feuille (40) vient se poser dans la zone d'une surface de contact correspondante (15, 17, 18, 20, 21) lors du laminage.

5. Procédé selon l'une des revendications précédentes, **caractérisé en ce que** la feuille coulée (41) est détachée après l'étape de laminage de la feuille (40) sur la surface (29).

6. Procédé selon l'une des revendications précédentes, **caractérisé en ce que** le vide est fait dans la seconde partie de chambre (35).

7. Procédé selon l'une des revendications précédentes, **caractérisé en ce qu'**il règne dans la première partie de chambre (33) au moins une pression isostatique.

8. Procédé selon l'une des revendications précédentes, **caractérisé en ce que**, pour augmenter la pression dans la première partie de chambre (33), un gaz, notamment de l'oxygène ou, plus préférablement, de l'azote, ou un gel, est alimenté dans la première partie de chambre (33).

9. Procédé selon l'une des revendications précédentes, **caractérisé en ce que** le substrat (11) avec l'au moins un composant (16, 19) sur une plaque de fond (37) de la chambre (31) pouvant être chauffée, le substrat (11) avec l'au moins un composant (16, 19) étant, tout comme la seconde partie de chambre (35), chauffé d'une manière définie par la plaque de fond (37).

10. Procédé selon l'une des revendications précédentes, **caractérisé en ce que** le contact entre la surface (29) du substrat (11) avec l'au moins un composant (16, 19) disposé dans la seconde partie de chambre (35) et le matériau composite en feuille (42) étant créé grâce à un mouvement relatif des partenaires de contact l'un vers l'autre.

11. Procédé selon l'une des revendications précédentes, **caractérisé en ce que**, avant l'étape du laminage, on produit, sur des parties (26) de l'au moins un composant (16, 19) s'étendant de manière essentiellement perpendiculaire au substrat (11), des flancs (28) qui relient des arêtes latérales (24, 25) du composant (16, 19) au substrat (11) en transition continue.

12. Procédé selon l'une des revendications précédentes, **caractérisé en ce que**, pour la post-cuisson ou la cuisson de la feuille laminée (40), le matériau composite demeure pendant un temps prédéterminé dans la chambre (31) en présence d'un profil de température prédéfini, notamment d'une température plus élevée que pour le processus de laminage.

13. Procédé selon l'une des revendications précédentes, **caractérisé en ce que**, pour la post-cuisson ou la cuisson de la feuille laminée (40), le produit semi-fini demeure pendant un temps prédéterminé à une température prédéfinie dans un four de trempe.

14. Procédé selon l'une des revendications précédentes, **caractérisé en ce que** l'on choisit, en tant que feuille (40) à laminer sur la surface (29), une feuille isolante ou une feuille photosensible (40) (feuille de papier photographique), notamment formée d'une matière isolante.

15. Procédé selon l'une des revendications précédentes, **caractérisé en ce que** la surface (29) sur laquelle la feuille (40) est laminée a une structure tridimensionnelle.
